# EUROPEAN PATENT APPLICATION

(11) **EP 4 749 301 A1**
(43) Date of publication of application: **27.05.2026**
(21) Application number: 25217639.1
(22) Date of filing: 21.11.2025
(51) Int. Cl.: G01R 31/26, G01R 31/327

(54) **A SYSTEM AND METHOD FOR DETECTING FAILURES OF SOLID-STATE SWITCHES IN A MAIN CIRCUIT**

(30) Priority: 22.11.2024 CN 202411678785
(71) Applicant: SCHNEIDER ELECTRIC INDUSTRIES SAS, 92500 Rueil-Malmaison (FR)
(72) Inventor: BAI, Wanlong, Shanghai, 201203 (CN); ZHU, Qilei, Shanghai, 201203 (CN); HUANG, Jie, Shanghai, 201203 (CN); BI, Baoyun, Shanghai, 201203 (CN); SHUANG, Bing, Shanghai, 201203 (CN); YING, Xiaoping, Shanghai, 201203 (CN)
(74) Representative: Openshaw & Co.

(57) **Abstract**

A system for detecting failures of solid-state switches in a main circuit includes: a first solid-state switch; a second solid-state switch connected in series with the first solid-state switch and in parallel with a diode; a voltage dividing resistor connected in series with the first solid-state switch and the second solid-state switch; and an injection unit configured to apply a voltage to a circuit including the first solid-state switch, the voltage dividing resistor, and the second solid-state switch. A control unit is configured to: transmit a first driving signal and a second driving signal to the first solid-state switch and the second solid-state switch, respectively, wherein the first driving signal and the second driving signal are used to indicate the switches to close; and determine whether the first and second solid-state switches have failures based on a voltage across the voltage dividing resistor.

## Description

### TECHNICAL FIELD

The present disclosure relates to failures in solid-state switches in a main circuit, and more specifically, the present disclosure relates to a system and method for detecting failures in solid-state switches in a main circuit in a case that there is no voltage in the main circuit.

### BACKGROUND

An electrical main circuit refers to a main circuit used for transferring electrical energy and typically includes a solid-state switch, a protective device, a cable, and other components. The main circuit is a basic channel for transferring electrical energy in an electrical system., Accordingly, effectively detecting and resolving failures in various electrical components in the main circuit is one of the keys to ensuring that the main circuit can work properly.

In the prior art, there is no corresponding detection signal to determine whether the solid-state switches in the main circuit have failures. In particular, in a case that there is no voltage in the main circuit, it is impossible to detect whether the control of the solid-state switches in the main circuit are normal in advance.

### SUMMARY

The present disclosure proposes a system and method for detecting failures of solid-state switches in a main circuit. According to the system and method proposed in the present disclosure, whether or not the solid-state switches have failures can be determined based on the measurement of a voltage value by injecting a voltage into a circuit including the solid-state switches and cooperating with the control of the solid-state switches in a case that there is no voltage in the main circuit.

According to an aspect of embodiments of the present invention, a system for detecting failures of solid-state switches in a main circuit is provided, the system comprising: a first solid-state switch; a second solid-state switch connected in series with the first solid-state switch and in parallel with a diode; a voltage dividing resistor connected in series with the first solid-state switch and the second solid-state switch; an injection unit configured to apply a voltage to a circuit including the first solid-state switch, the voltage dividing resistor, and the second solid-state switch; and a control unit configured to: transmit a first driving signal and a second driving signal to the first solid-state switch and the second solid-state switch, respectively, wherein the first driving signal and the second driving signal are used to indicate the switches to close; and determine whether the first solid-state switch and the second solid-state switch have failures based on a voltage across the voltage dividing resistor, wherein the first solid-state switch, the voltage dividing resistor, and the second solid-state switch are sequentially connected in series in the main circuit, and wherein there is no voltage in the main circuit.

In some examples, the control unit is further configured to determine that the first solid-state switch has an open-circuit failure when the voltage across the voltage dividing resistor is equal to zero.

In some examples, the control unit is further configured to transmit a third driving signal to the second solid-state switch when the voltage across the voltage dividing resistor is equal to a first target voltage, wherein the third driving signal is used to indicate the switch to open, and wherein the first target voltage is preset.

In some examples, in a case of transmitting the third driving signal to the second solid-state switch, the control unit is further configured to determine that the second solid-state switch has a short-circuit failure when the voltage across the voltage dividing resistor is not equal to a second target voltage, wherein the second target voltage is preset, and determine that the second solid-state switch does not have a failure, and transmit a fourth driving signal to the first solid-state switch when the voltage across the voltage dividing resistor is equal to the second target voltage, wherein the fourth driving signal is used to indicate the switch to open.

In some examples, in a case of transmitting the fourth driving signal to the first solid-state switch, the control unit is further configured to determine that the first solid-state switch does not have a failure when the voltage across the voltage dividing resistor is equal to zero; and determine that the first solid-state switch has a short-circuit failure when the voltage across the voltage dividing resistor is not equal to zero.

In some examples, the control unit is further configured to determine that the second solid-state switch has an open-loop failure when the voltage across the voltage dividing resistor is equal to the second target voltage, and transmit a fourth driving signal to the first solid-state switch.

In some examples, in a case of transmitting the fourth driving signal to the first solid-state switch, the control unit is further configured to determine that the first solid-state switch does not have a failure when the voltage across the voltage dividing resistor is equal to zero; and determine that the first solid-state switch has a short-circuit failure when the voltage across the voltage dividing resistor is not equal to zero.

In some examples, the injection unit includes a power supply and a relay.

In some examples, the power supply of the injection unit is independent from a power supply of the main circuit.

In some examples, the control unit is further configured to transmit a driving signal to the relay of the injection unit to control opening and closing of the relay.

In some examples, the first solid-state switch and the second solid-state switch are silicon carbide (SiC) metal-oxide semiconductor field effect transistors (MOSFETs).

According to an aspect of an embodiment of the present invention, a method for detecting failures of solid-state switches in a main circuit is provided, the method comprising: applying, by an injection unit, a voltage to a circuit including a first solid-state switch, a voltage dividing resistor, and a second solid-state switch; transmitting, by a control unit, a first driving signal and a second driving signal to the first solid-state switch and the second solid-state switch, respectively, wherein the first driving signal and the second driving signal are used to indicate the switches to close; and determining, by the control unit, whether the first solid-state switch and the second solid-state switch have failures based on a voltage across the voltage dividing resistor, wherein the first solid-state switch, the voltage dividing resistor, and the second solid-state switch are sequentially connected in series in the main circuit, the second solid-state switch is connected in parallel with a diode, and wherein there is no voltage in the main circuit.

In some examples, the first solid-state switch and the second solid-state switch are silicon carbide (SiC) metal-oxide semiconductor field effect transistors (MOSFETs).

According to an aspect of embodiments of the present invention, a computer-readable storage medium having stored thereon computer-executable instructions is provided, when executed by a processor, the instructions are used to implement the foregoing methods.

Other aspects, advantages, and salient features of the present disclosure will become clear to those skilled in the art from the following detailed description in conjunction with the accompanying drawings which disclose various embodiments of the present disclosure.

### BRIEF DESCRIPTION OF THE DRAWINGS

The present invention will be more readily understood by the following detailed description with the aid of the accompanying drawings, wherein the same symbols designate units of the same construction and in which:
FIG. 1 illustrates a circuit topology for detecting failures of solid-state switches in a main circuit according to embodiments of the present disclosure;
FIG. 2 illustrates a schematic diagram of a circuit for detecting failures of solid-state switches in a main circuit according to embodiments of the present disclosure;
FIG. 3 illustrates a flowchart of a method for detecting failures of solid-state switches in a main circuit according to embodiments of the present disclosure; and
FIG. 4 illustrates a schematic diagram of a non-transitory computer-readable medium according to embodiments of the present disclosure.
Throughout the accompanying drawings, similar reference numerals will be understood to refer to similar parts, components, and structures.

### DETAILED DESCRIPTION

The technical solutions in the embodiments of the present invention will be described clearly and completely in the following in conjunction with the accompanying drawings in the embodiments of the present invention, and it is obvious that the described embodiments are a part of the embodiments of the present invention instead of all of the embodiments. Based on the embodiments in the present invention, all other embodiments obtained by a person of ordinary skill in the art without making creative labor fall within the scope of protection of the present invention.

In addition, one of ordinary skill in the art will understand that the elements in the accompanying drawings are illustrated for simplicity and may not necessarily be drawn to scale. For example, the dimensions of some elements in the accompanying drawings may be enlarged relative to other elements to help improve understanding of aspects of the embodiments. In addition, one or more elements may have been represented by various symbols in the accompanying drawings, and the accompanying drawings may show only those particular details that are relevant to an understanding of the embodiments of the present disclosure so that the accompanying drawings do not have to be obscured by details that would be obvious to a person of ordinary skill in the art who would benefit from the descriptions herein.

In addition, it should be noted that in this specification, A connected to B may mean "A is directly connected to B" or "A is connected to B via other intermediate". A connected between B and C may mean "A is directly connected to B and C" or "A is connected to B and C via other middleware". In addition, it should be noted that in this specification, "first" and "second" are used only to distinguish one element from another element, and are not used to rank or limit the importance or priority of different elements.

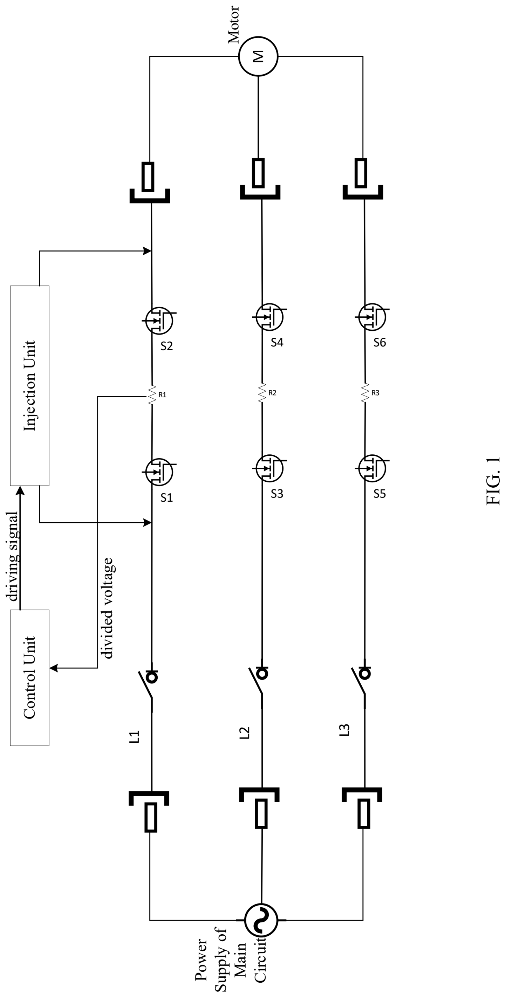

FIG. 1 illustrates an example of a circuit topology for detecting failures in solid-state switches in a main circuit, according to embodiments of the present disclosure.

A main circuit refers to a main circuit used for transferring electrical energy in an electrical system or an electrical device, and typically includes switches, protective devices, cables, and other components. As shown in FIG. 1, the main circuits L1, L2, and L3 are illustrated, respectively. The main circuits L1, L2, and L3 are connected between a power supply of the main circuit and a load, such as a motor, for transferring electrical energy. As shown in FIG. 1, each of the main circuits also includes solid-state switches and a voltage dividing resistor, respectively. For example, in the main circuit L1, a first solid-state switch S1, a voltage dividing resistor R1, and a second solid-state switch S2 are connected in series. Similarly, in the main circuit L2, a first solid-state switch S3, a voltage dividing resistor R2 and a second solid-state switch S4 are connected in series, and in the main circuit L3, a first solid-state switch S5, a voltage dividing resistor R3 and a second solid-state switch S6 are connected in series.

When there is no voltage in the main circuit, with respect to the solid-state switches in the main circuit, there is currently no method in the art for determining whether the solid-state switches have failures. To this end, the present disclosure proposes a system and method capable of determining whether the solid-state switches in the main circuit have failures when there is no voltage in the main circuit. Taking the main circuit L1 as an example, when there is no voltage in the main circuit , the injection unit may apply a voltage to the first solid-state switch S1, the voltage dividing resistor R1, and the second solid-state switch S2 connected in series in the main circuit L1, and the control unit may determine whether the first solid-state switch S1 and the second solid-state switch S2 have failures based on the voltage across the voltage dividing resistor R1.

As shown in FIG. 1, the injection unit may apply a voltage to the first solid-state switch S1, the voltage dividing resistor R1, and the second solid-state switch S2 connected in series in the main circuit L1. The control unit may control the injection unit to apply a voltage to the first solid-state switch S1, the voltage dividing resistor R1, and the second solid-state switch S2 connected in series. In some embodiments, the injection unit may include a power supply and a relay, and the control unit may control the opening and closing of the relay of the injection unit by transmitting a driving signal to the relay, so as to control the operation of applying the voltage by the injection unit. In some embodiments, the power supply of the injection unit is different from the power supply of the main circuit.

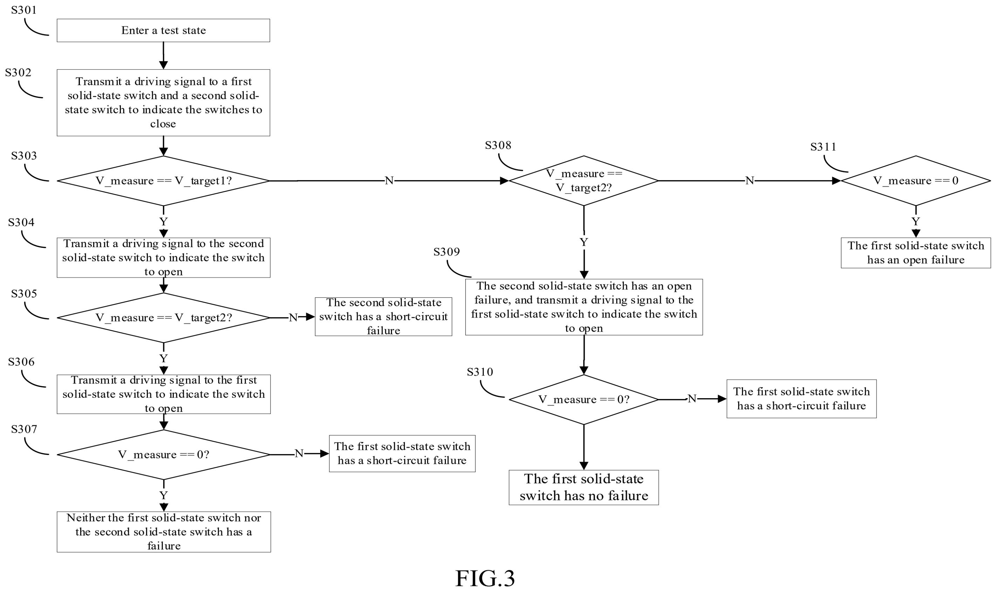

The control unit may transmit driving signals to the first solid-state switch S1 and the second solid-state switch S2 respectively to control the opening and closing of the first solid-state switch S1 and the second solid-state switch S2. In addition, the control unit may receive a voltage of the voltage dividing resistor R1 and determine whether the first solid-state switch S1 and the second solid-state switch S2 have failures based on the voltage across the voltage dividing resistor R1. A process for determining whether solid-state switches have failures based on the voltage across the voltage dividing resistor will be specifically described with reference to FIG. 3.

In some embodiments, the control unit may be a microcontrol unit MCU. in some embodiments, the solid-state switches may be silicon carbide (SiC) metal-oxide semiconductor field effect transistors (MOSFETs). However, the present disclosure is not limited to this, and the control unit may be any electronic component having a control function and the solid-state switches may be any suitable switches.

It should be understood that while FIG. 1 illustrates a circuit topology for determining whether solid-state switches have failures only for the first solid-state switch S1 and the second solid-state switch S2 in the main circuit L1, a similar circuit topology may be equally applicable for determining whether other solid-state switches in the main circuit have failures.

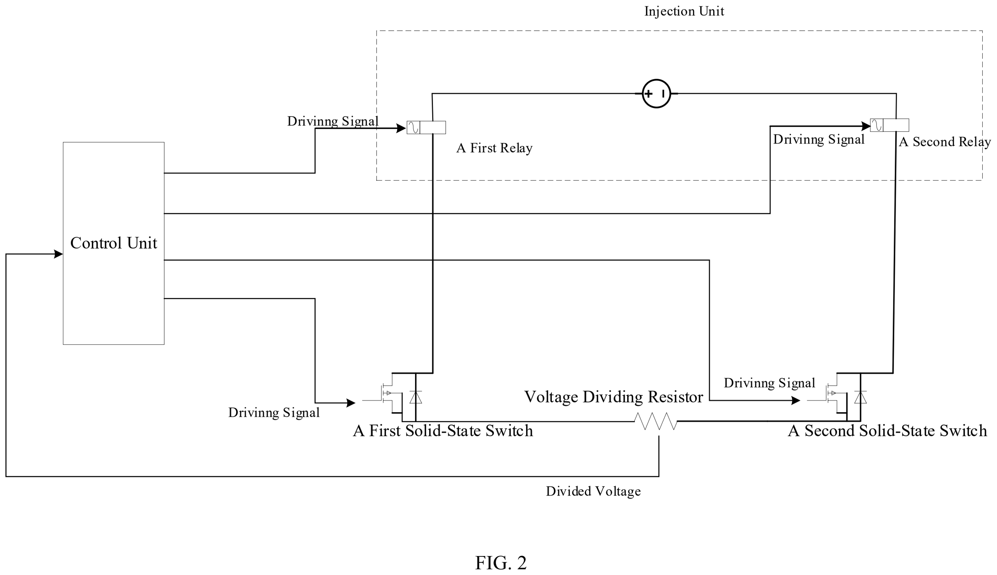

FIG. 2 illustrates a schematic diagram of a circuit for detecting failures of solid-state switches in a main circuit according to embodiments of the present disclosure.

As shown in FIG. 2, an injection unit applies a voltage to a circuit including a first solid-state switch, a voltage dividing resistor, and a second solid-state switch, and the first solid-state switch, the voltage dividing resistor, and the second solid-state switch are sequentially connected in series. The injection unit may include a power supply and a relay. The control unit may transmit a driving signal to the relay of the injection unit to control the opening and closing of the relay, thereby controlling the injection unit to apply a voltage to the circuit including the first solid-state switch, the voltage dividing resistor, and the second solid-state switch. For example, in FIG. 2, the injection unit includes a power supply, a first relay, and a second relay, and the control unit may transmit driving signals to the first relay and the second relay to control the opening and closing of the first relay and the second relay, respectively. The injection unit shown in FIG. 2 is only illustrated as an example, and the injection unit may include more or fewer components depending on the actual application scenario.

Although the main circuit is not shown in FIG. 2, the first solid-state switch, the voltage dividing resistor, and the second solid-state switch are sequentially connected in series in the main circuit. The first solid-state switch is connected in parallel with the backward-biased diode and the second solid-state switch is connected in parallel with the forward-biased diode. When both the first solid-state switch and the second solid-state switch are closed, the voltage across the voltage dividing resistor is not zero and may be referred to as a first target voltage. When the first solid-state switch is closed and the second solid-state switch is opened, the diode connected in parallel with the second solid-state switch is turned-on, the voltage across the voltage dividing resistor is not zero and may be referred to as a second target voltage. When the first solid-state switch is opened, the loop is opened regardless of whether the second solid-state switch is closed, and the voltage across the voltage dividing resistor is zero.

The control unit may transmit driving signals to the first solid-state switch and the second solid-state switch respectively to control the opening and closing of the first solid-state switch and the second solid-state switch. For example, the control unit may transmit a driving signal (such as a first driving signal) to the first solid-state switch to indicate the first solid-state switch to close or transmit a driving signal (such as a fourth driving signal) to the first solid-state switch to indicate the first solid-state switch to open, and may transmit a driving signal (such as a second driving signal) to the second solid-state switch to indicate the second solid-state signal to close or transmit a driving signal (such as a third driving signal) to the second solid-state switch to indicate the second solid-state switch to open. Furthermore, after the control unit transmits the driving signal to the first solid-state switch and/or the second solid-state switch, the control unit may receive a voltage across the voltage dividing resistor and determine whether the first solid-state switch and the second solid-state switch have failures based on the voltage across the voltage dividing resistor. A process for determining whether the solid-state switches have failures based on the voltage of the voltage dividing resistor will be specifically described with reference to FIG. 3.

FIG. 3 illustrates a flowchart of a method for detecting failures of solid-state switches in a main circuit according to embodiments of the present disclosure.

As shown in FIG. 3, at step S301, the system enters a test state, and the first solid-state switch and the second solid-state switch are opened. When there is no voltage in the main circuit, a voltage is applied by the injection unit to the circuit including the first solid-state switch, the voltage dividing resistor, and the second solid-state switch. In some embodiments, the control unit may transmit a driving signal to the injection unit to control the injection unit to apply the voltage to the circuit including the first solid-state switch, the voltage dividing resistor, and the second solid-state switch. For example, the control unit may transmit a driving signal to a relay of the injection unit to control opening and closing of the relay, so as to control the operation of the injection unit. In some embodiments, the first solid-state switch, the voltage dividing resistor, and the second solid-state switch are sequentially connected in series, and the second solid-state switch is connected in parallel with a diode.

At step S302, the control unit may transmit a first driving signal and a second driving signal to the first solid-state switch and the second solid-state switch, respectively, and the first driving signal and the second driving signal are used to indicate the first solid-state switch and the second solid-state switch to close, respectively.

At step S303, the control unit may receive a voltage across the voltage dividing resistor V_measure and determine whether the voltage across the voltage dividing resistor V_measure is equal to a first target voltage V_target1. The first target voltage V_target1 is a voltage across the voltage dividing resistor in a case that the first solid-state switch and the second solid-state switch are closed. Depending on the magnitude of the voltage applied by the injection unit, the resistance of the first solid-state switch and the second solid-state switch, the resistance of the voltage dividing resistor, and the resistance of other components in the system, the first target voltage V_target1 may be preset differently.

At step S303, when the voltage across the voltage dividing resistor V_measure is equal to the first target voltage V_target1 , it can be determined that both the first solid-state switch and the second solid-state switch are properly closed, and the process proceeds to step S304, and when the voltage across the voltage dividing resistor V_measure is not equal to the first target voltage V_target1 , it can be determined that at least one of the first solid-state switch and the second solid-state switch is not properly closed, and the process proceeds to step S308.

At step S304, the control unit may transmit a third driving signal to the second solid-state switch, and the third driving signal is used to indicate that the second solid-state switch to open.

At step S305, the control unit may receive the voltage across the voltage dividing resistor V_measure and determine whether the voltage across the voltage dividing resistor V_measure is equal to a second target voltage V_target2. The second target voltage V_target2 is a voltage across the voltage dividing resistor in a case that the first solid-state switch is closed and the second solid-state switch is opened. Since the second solid-state switch is connected in parallel with the diode, when the second solid-state switch is opened, the diode is turned-on and the voltage across the voltage dividing resistor changes. Depending on the magnitude of the voltage applied by the injection unit, the resistance of the first solid-state switch, the resistance of the voltage dividing resistor, the resistance of the diode, and the resistance of other components in the system, the second target voltage V_target2 may be preset differently.

At step S305, if the voltage across the voltage dividing resistor V_measure is not equal to the second target voltage V_target2, it can be determined that the second solid-state switch has a short-circuit failure. At step S303, it has been determined that both the first solid-state switch and the second solid-state switch are properly closed, and at step S304, the second solid-state switch receives a third driving signal indicating the second solid-state switch to open. If the voltage across the voltage dividing resistor V_measure is equal to the second target voltage V_target2, it can be determined that the second solid-state switch is successfully opened after receiving the third driving signal. However, if the voltage across the voltage dividing resistor V_measure is not equal to the second target voltage V_target2, it may be determined that the second solid-state switch is not successfully opened after receiving the third driving signal, i.e., the second solid-state switch has a short-circuit failure.

At step S305, when the voltage across the voltage dividing resistor V_measure is equal to the second target voltage V_target2, it may be determined that the second solid-state switch is properly opened, and the process proceeds to step S306.

At step S306, the control unit may transmit the fourth driving signal to the first solid-state switch, and the fourth driving signal is used to indicate the first solid-state switch to open.

At step S307, the control unit may receive the voltage across the voltage dividing resistor V_measure and determine whether the voltage across the voltage dividing resistor V_measure is equal to zero. When the first solid-state switch is opened, the circuit is opened and the voltage across the voltage dividing resistor is zero. If the voltage across the voltage dividing resistor V_measure is equal to zero, it can be determined that the first solid-state switch is properly opened. At this time, it may be determined that both the first solid-state switch and the second solid-state switch are capable to be properly opened and closed according to the received driving signals, i.e., it may be determined that the first solid-state switch and the second solid-state switch do not have a failure. If the voltage across the voltage dividing resistor V_measure is not equal to zero, it may be determined that the first solid-state switch fails to open properly, i.e., the first solid-state switch has a short-circuit failure.

As shown previously, at step S303, when the voltage across the voltage dividing resistor V_measure is not equal to the first target voltage V_target1, it can be determined that at least one of the first solid-state switch and the second solid-state switch fails to close properly, the process proceeds to step S308.

At step S308, the control unit may receive the voltage across the voltage dividing resistor V_measure and determine whether the voltage across the voltage dividing resistor V_measure is equal to the second target voltage V_target2. As described previously, the second target voltage V_target2 is the voltage across the voltage dividing resistor in a case that the first solid-state switch is closed and the second solid-state switch is opened. At step S308, when the voltage across the voltage dividing resistor V_measure is equal to the second target voltage V_target2, it may be determined that the second solid-state switch has an open-loop failure, and the process proceeds to step S309, and when the voltage across the voltage dividing resistor V_measure is not equal to the second target voltage V_target2, the process proceeds to step S311.

At step S308, if the voltage across the voltage dividing resistor V_measure is equal to the second target voltage V_target2, it may be determined that the second solid-state switch has an open-loop failure. At step S303, it has been determined that at least one of the first solid-state switch and the second solid-state switch is not properly closed, and in step S305, it is determined that the voltage across the voltage dividing resistor V_measure is equal to the second target voltage V_target2, i.e., the voltage across the voltage dividing resistor V_measure is equal to the voltage across the voltage dividing resistor in a case that the first solid-state switch is closed and the second solid-state switch is opened, i.e., it may be determined that the second solid-state switch is not successfully closed after receiving the second driving signal, i.e., the second solid-state switch has an open-loop failure.

At step S309, the control unit may transmit the fourth driving signal to the first solid-state switch. The fourth driving signal is used to indicate the first solid-state switch to open.

At step S310, the control unit may receive the voltage across the voltage dividing resistor V_measure and determine whether the voltage across the voltage dividing resistor V_measure is equal to zero. When the first solid-state switch is opened, the circuit is disconnected and the voltage across the voltage dividing resistor is zero. If the voltage across the voltage dividing resistor V_measure is equal to zero, it may be determined that the first solid-state switch is properly opened. At this time, it may be determined that the first solid-state switch may be properly opened and closed based on the received driving signals, i.e., it can be determined that the first solid-state switch does not have a failure. If the voltage across the voltage dividing resistor V_measure is not equal to zero, it may be determined that the first solid-state switch fails to open properly, i.e., the first solid-state switch has a short-circuit failure.

As shown previously, at step S308, when the voltage across the voltage dividing resistor V_measure is not equal to the second target voltage V_target2, the process proceeds to step S311.

At step S311, the control unit may receive the voltage across the voltage dividing resistor V_measure and determine whether the voltage across the voltage dividing resistor V_measure is equal to zero. When the first solid-state switch is opened, the circuit is disconnected and the voltage across the voltage dividing resistor is zero. If the voltage across the voltage dividing resistor V_measure is equal to zero, it may be determined that the first solid-state switch has an open-loop failure. At step S303, it has been determined that at least one of the first solid-state switch and the second solid-state switch fails to close properly, and it is determined at step S311 that the voltage across the voltage dividing resistor V_measure is equal to zero, i.e., the voltage across the voltage dividing resistor V_measure is equal to the voltage across the voltage dividing resistor in a case that the first solid-state switch is opened, i.e., it may be determined that the first solid-state switch does not successfully close after receiving the first driving signal, i.e., the first solid-state switch has an open-loop failure.

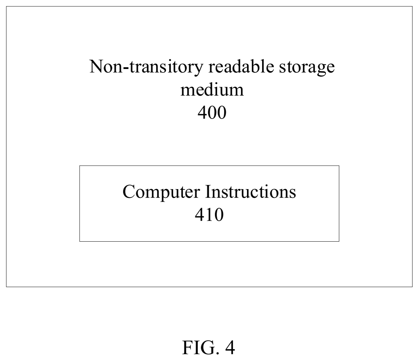

FIG. 4 illustrates a schematic view of a non-transitory computer readable medium in accordance with embodiments of the present disclosure.

As shown in FIG. 4, the non-transitory readable storage medium 400 has computer instructions 410 stored thereon. When the computer instructions 410 are executed by a processor, the processor may perform one or more of the steps in the method and additional aspects thereof as described above.

Exemplarily, the non-transitory readable storage medium 400 may be any combination of one or more computer-readable storagemedia, such as a computer-readable storage medium comprising program code for performing the various methods described above.

Exemplarily, when the program code is read by a computer, the computer may execute the program code stored in the computer storage medium, and perform one or more steps to implement, for example, the various methods described above and additional aspects thereof according to at least one embodiment of the present disclosure.

One of ordinary skill in the art may realize that the units and algorithmic steps of the embodiments described in connection with the embodiments disclosed in the present specification are capable of being realized in electronic hardware, computer software, or a combination of both, and that the composition and steps of the embodiments have been described in the foregoing description in general terms according to the functions, in order to clearly illustrate the interchangeability of hardware and software. Whether these functions are performed in hardware or software depends on the particular application and design constraints of the technical solution. The skilled person may use different methods for each particular application to implement the described functions, but such implementation should not be considered beyond the scope of the present invention.

It is clear to those skilled in the field to which it belongs that, for the convenience and brevity of the description, the specific working processes of the above-described systems, apparatuses and units may be referred to the corresponding processes in the foregoing embodiments of the methods, which will not be repeated herein.

In the several embodiments provided in the present invention, it should be understood that the disclosed systems, apparatuses and methods, may be realized in other ways. For example, the above-described embodiments of the device are merely example, e.g., the division of the units described, is merely a logical functional division, and the actual implementation may be divided in other ways, e.g., a plurality of units or components may be combined or may be integrated into another system, or some of the features may be ignored, or not implemented. Another point is that the mutual coupling or direct coupling or communication connection shown or discussed may be an indirect coupling or communication connection through some interface, device or unit, which may be electrical, mechanical or otherwise.

The units illustrated as separated components may or may not be physically separated, and components displayed as units may or may not be physical units, and may either be located in one place or may be distributed over a plurality of network units. Some or all of these units may be selected to fulfill the purpose of this embodiment scheme according to actual needs.

Furthermore, the functional units in the various embodiments of the present invention may be integrated in a single processing unit, or each unit may be physically present separately, or two or more units may be integrated in a single unit. The integrated unit may be realized either in the form of hardware or in the form of a software functional unit.

The integrated units may be stored in a computer-readable storage medium if realized in the form of a software functional unit and sold or used as a separate product. Based on this understanding, the technical solution of the present invention, in essence or as a contribution to the prior art, or all or part of the technical solution, may be embodied in the form of a software product, which is stored in a storage medium comprising a number of instructions to enable a computer device (which may be a personal computer, a server, or a network device, etc.) to carry out all or part of the steps of the method described in various embodiments of the invention, and the computer software product is stored in a storage medium comprising instructions to cause a computer device (which may be a personal computer, a server, a network device, etc.) to perform all or part of the steps of the method described in the various embodiments of the invention. The aforementioned storage medium includes a USB flash drive, a removable hard disk, a read-only memory (ROM, Read-Only Memory), a random access memory (RAM, Random Access Memory), a diskette or a CD-ROM, and other media that may store program code.

The foregoing are only specific embodiments of the present invention, but the scope of protection of the present invention is not limited thereto, and any person skilled in the art who is familiar with the technical field can easily think of changes or substitutions within the scope of the technology disclosed by the present invention, which should be covered by the scope of protection of the present invention. Therefore, the scope of protection of the present invention shall be stated to be subject to the scope of protection of the claims.

## Claims

1. A system for detecting failures of solid-state switches in a main circuit, the system comprising:
a first solid-state switch;
a second solid-state switch connected in series with the first solid-state switch and in parallel with a diode;
a voltage dividing resistor connected in series with the first solid-state switch and the second solid-state switch;
an injection unit configured to apply a voltage to a circuit including the first solid-state switch, the voltage dividing resistor, and the second solid-state switch; and
a control unit configured to:
transmit (S302) a first driving signal to the first solid-state switch and transmit a second driving signal to the second solid-state switch, wherein the first driving signal and the second driving signal are used to indicate the switches to close; and
determine whether the first solid-state switch and the second solid-state switch have failures based on a voltage across the voltage dividing resistor,
wherein the first solid-state switch, the voltage dividing resistor, and the second solid-state switch are sequentially connected in series in the main circuit, and wherein there is no voltage in the main circuit.

2. The system of claim 1, wherein the control unit is configured to determine that the first solid-state switch has an open-circuit failure when the voltage across the voltage dividing resistor is equal to zero.

3. The system of claim 1 or claim 2, wherein the control unit is configured to transmit (304) a third driving signal to the second solid-state switch when the voltage across the voltage dividing resistor is equal to a first target voltage, wherein the third driving signal is used to indicate the switch to open, and wherein the first target voltage is preset.

4. The system of claim 3, wherein in a case of transmitting the third driving signal to the second solid-state switch, the control unit is configured to:
determine (305) that the second solid-state switch has a short-circuit failure when the voltage across the voltage dividing resistor is not equal to a second target voltage, wherein the second target voltage is preset, and
determine (305) that the second solid-state switch does not have a failure when the voltage across the voltage dividing resistor is equal to the second target voltage, and transmit (306) a fourth driving signal to the first solid-state switch, wherein the fourth driving signal is used to indicate the switch to open.

5. The system of claim 4, wherein in a case of transmitting (306) the fourth driving signal to the first solid-state switch, the control unit is configured to:
determine (307) that the first solid-state switch does not have a failure when the voltage across the voltage dividing resistor is equal to zero; and
determine (307) that the first solid-state switch has a short-circuit failure when the voltage across the voltage dividing resistor is not equal to zero.

6. The system of any of claims 1 to 5, wherein the control unit is configured to:
determine (308) that the second solid-state switch has an open-loop failure when the voltage across the voltage dividing resistor is equal to a second target voltage, and transmit (309) a fourth driving signal to the first solid-state switch.

7. The system of claim 6, wherein in a case of transmitting (309) the fourth driving signal to the first solid-state switch, the control unit is configured to:
determine (310) that the first solid-state switch does not have a failure when the voltage across the voltage dividing resistor is equal to zero; and
determine (310) that the first solid-state switch has a short-circuit failure when the voltage across the voltage dividing resistor is not equal to zero.

8. The system of any of claims 1 to 7, wherein the injection unit includes a power supply and a relay.

9. The system of claim 8, wherein the power supply is independent of a power supply of the main circuit.

10. The system of claim 8 or claim 9, wherein the control unit is configured to transmit a driving signal to the relay of the injection unit to control opening and closing of the relay.

11. The system of any of claims 1 to 10, wherein the first solid-state switch and the second solid-state switch are silicon carbide, SiC, metal-oxide semiconductor field effect transistors, MOSFETs.

12. A method for detecting failures of solid-state switches in a main circuit, the method comprising:
applying, by an injection unit, a voltage to a circuit including a first solid-state switch, a voltage dividing resistor, and a second solid-state switch;
transmitting, by a control unit, a first driving signal to the first solid-state switch and transmitting, by the control unit, a second driving signal to the second solid-state switch, wherein the first driving signal and the second driving signal are used to indicate the switches to close; and
determining, by the control unit, whether the first solid-state switch and the second solid-state switch have failures based on a voltage across the voltage dividing resistor,
wherein the first solid-state switch, the voltage dividing resistor, and the second solid-state switch are sequentially connected in series in the main circuit, the second solid-state switch is connected in parallel with a diode, and wherein there is no voltage in the main circuit.

13. The method of claim 12, wherein the first solid-state switch and the second solid-state switch are silicon carbide, SiC, metal-oxide semiconductor field effect transistors, MOSFETs.

14. A computer program comprising computer-executable instructions, which, when executed by a processor, implement the method of claim 12 or claim 13.
